# EUROPEAN PATENT APPLICATION

(11) **EP 4 586 748 A1**
(43) Date of publication of application: **16.07.2025**
(21) Application number: 23898105.4
(22) Date of filing: 02.11.2023
(51) Int. Cl.: H05K 5/00

(54) **DISPLAY DEVICE, AND FRAME FOR DISPLAY DEVICE**

(30) Priority: 30.11.2022 KR 20220164525
(71) Applicant: Tovis Co., Ltd., Incheon 22011 (KR)
(72) Inventor: SUN, Jae Sung, Yongin-si Gyeonggi-do 16978 (KR); MO, Jeong Hwan, Seoul 05385 (KR)
(74) Representative: BCKIP Part mbB
(86) International application number: PCT/KR2023/017332
(87) International publication number: WO 2024/117573

(57) **Abstract**

An object of the present invention is to provide a display device that allows a module assembly to be easily coupled to a frame in an aligned state while uniformly maintaining a coupling gap between the module assembly and the frame. The display device according to an embodiment of the present invention may comprise a module assembly to which a display panel is coupled, the module assembly comprising a first sidewall formed along an outer edge of the display panel, a frame comprising a second sidewall facing the first sidewall, a screw configured to fasten the first sidewall and the second sidewall to each other and a gap limiting member disposed between the first sidewall and the second sidewall to determine a gap between the first sidewall and the second sidewall.

## Description

### Technical field

The present disclosure relates to a display device, and more particularly, to a display device in which the accuracy and convenience of assembly work are improved between a module assembly to which a display panel is coupled and a frame which is coupled to the outer side of the module assembly at gaps.

### Background Art

In general, an LCD and an LED device include a display panel for displaying an image, a module assembly coupled to support the outside of the display panel, and a frame assembled with the module assembly at a predetermined gap.

Here, since the module assembly and the frame are assembled at gaps therebetween, the module assembly and the frame need to be assembled while maintaining gaps formed in all directions substantially equal to each other.

However, the display device according to the related art has a disadvantage in that it is difficult to assemble the module assembly while maintaining a gap between the module assembly and the frame.

### Disclosure

### Technical problem

The present disclosure has been made in an effort to solve at least some of the problems of the prior art as described above, and an object of the present disclosure is to provide a display device capable of coupling a module assembly to a frame in a state in which the module assembly is easily aligned while maintaining a coupling gap between the module assembly and the frame to be uniform.

### Technical Solution

A display device according to an embodiment of the present invention may comprise a module assembly to which a display panel is coupled, the module assembly comprising a first sidewall formed along an outer edge of the display panel, a frame comprising a second sidewall facing the first sidewall, a screw configured to fasten the first sidewall and the second sidewall to each other and a gap limiting member disposed between the first sidewall and the second sidewall to determine a gap between the first sidewall and the second sidewall.

In one embodiment, the gap limiting members are disposed in plurality along the outer edge of the module assembly, at least one pair of the gap limiting members being disposed at symmetrical positions on an upper side and a lower side of the module assembly, and at least one pair of the gap limiting members being disposed at symmetrical positions on a left side and a right side of the module assembly.

In one embodiment, the gap limiting member is formed by embossing the second sidewall and integrally protruding from an inner surface of the second sidewall.

In one embodiment, the screws are disposed in plurality along the outer edge of the module assembly, at least one pair of the screws being disposed at symmetrical positions on an upper side and a lower side of the module assembly, and at least one pair of the screws being disposed at symmetrical positions on a left side and a right side of the module assembly, and the pair of the gap limiting members are symmetrically disposed with respect to the screw.

In one embodiment, the second sidewall comprises a cut-out portion formed by cutting both sides of the screw in a direction from one end portion of the second sidewall in a width direction to the other end portion thereof.

In one embodiment, the gap limiting member is disposed between the screw and the cut-out portion.

In one embodiment, the gap limiting member is disposed closer to the screw between the screw and the cut-out portion.

A frame according to another embodiment of the present invention may be installed in a housing of a gaming machine such as a slot machine, coupled with a module assembly, and serving as a medium to mount a display panel to the housing of the gaming machine. The frame may comprise a bezel portion surrounding an outer edge of an image display surface of the display panel in parallel with the image display surface, a second sidewall bent vertically from the outer edge of the bezel portion to a rear side of the display panel and disposed to face a first sidewall of the module assembly and a gap limiting member disposed between the first sidewall and the second sidewall.

The means for solving the above-described problems do not enumerate all features of the present invention. Various means for solving the problems of the present invention will be more clearly understood with reference to specific embodiments described in detail below.

### Advantageous Effects

According to one embodiment of the present disclosure having such a configuration, assembly accuracy and precision between the module assembly and the frame may be improved, and assembly difficulty may be reduced, so that the probability of deformation and damage of the display device may be significantly reduced.

### Description of Drawings

FIG. 1 is a perspective view showing a state in which a module assembly and a frame are assembled, according to an embodiment of the present invention.
FIG. 2 is a perspective view of a frame included in the display device shown in FIG. 1.
FIG. 3 is a front view illustrating a region around a screw provided on the second sidewall of the frame shown in FIG. 2.
FIG. 4 is a side view of a gap limiting member comprised in the display device shown in FIG. 1.
FIG. 5 is a cross-sectional view schematically illustrating a coupling structure between a module assembly and a frame comprised in a display device according to an embodiment of the present disclosure.
FIG. 6 is a cross-sectional view schematically illustrating a coupling structure between a module assembly and a frame comprised in a display device according to the related art.

### Best mode

The terminology used in this disclosure is intended only to describe specific embodiments and is not intended to limit the scope of the present disclosure. Further, the singular forms used in this specification are intended to include the plural forms as well, unless the context clearly indicates otherwise.

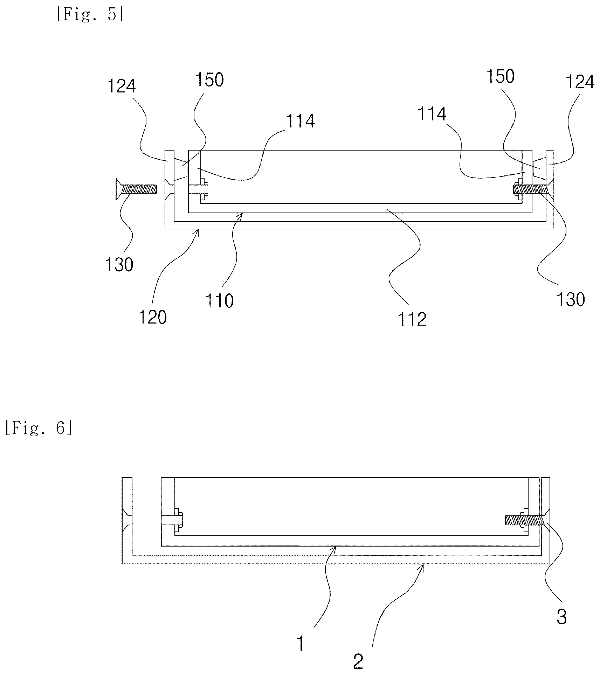

First, a coupling structure of a module assembly and a frame of a display device according to a comparative example will be described with reference to FIG. 6.

Referring to FIG. 6, in a comparative example, that is, in the related art, in the process of coupling the frame 2 with the screw 3, when a force is applied to couple the screw 3 on one side of the frame 2, as illustrated in FIG. 6, the module assembly 1 follows in the coupling direction, and thus, the gap between the module assembly 1 and the frame 2 located on the opposite side is increased to be longer than the set gap. When the gap larger than the set gap is generated as described above, the frame 2 is tilted, and the frame 2 that is not aligned and the module assembly 1 are forcibly coupled to each other, and as a result, the product may be deformed or damaged.

In particular, in the case of a display device installed in a game machine such as a slot machine, since game machines are arranged in a row and a mechanism structure such as a manipulation device for game play is also provided under the display device, the module assembly 1 and the frame 2 may be coupled only in one direction or in two directions, and in the case where the coupling direction is limited as described above, in particular, when the coupling gap between the module assembly 1 and the frame 2 is not uniform, installation work of the display device may fail or the display device may be deformed or damaged.

Hereinafter, embodiments of the present diclosure will be described with reference to the accompanying drawings.

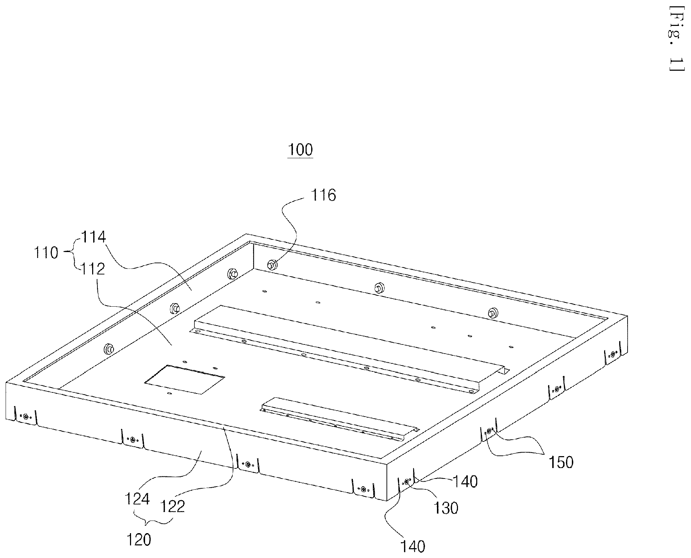

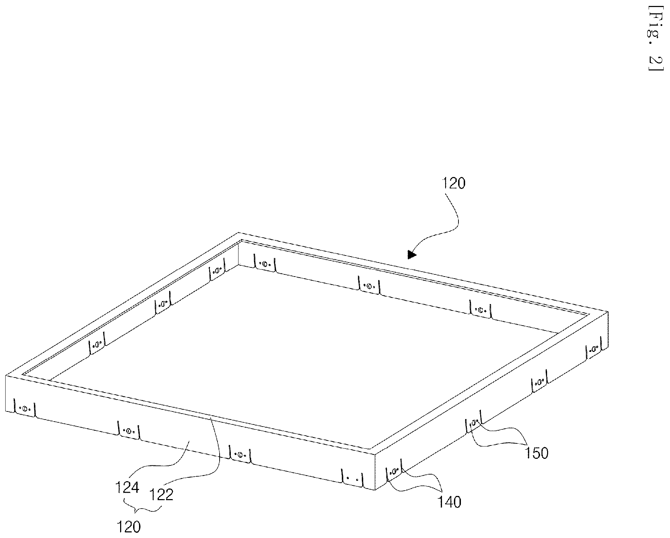

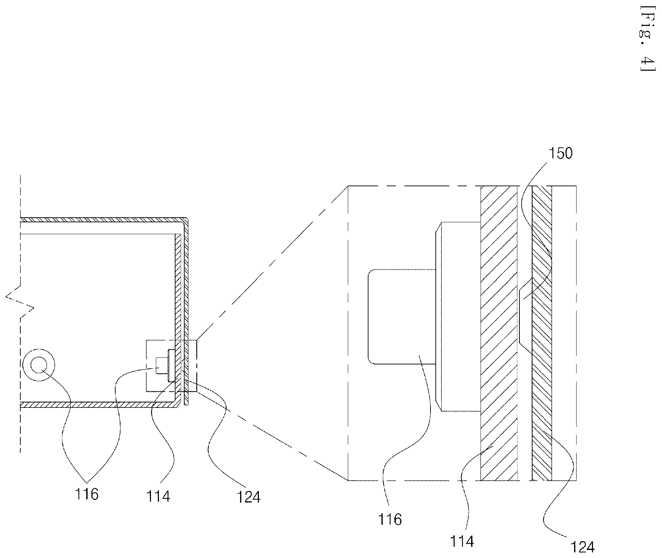

First, a display device 100 according to one embodiment of the present invention will be described with reference to FIGS. 1 to 4.

As illustrated in FIGS. 1 to 4, a display apparatus 100 according to one embodiment of the present disclosure may include a module assembly 110, a frame 120, a screw 130, a cut-out portion 140, and a gap limiting member 150.

The module assembly 110 is a member coupled to a display panel (not shown), and may include a rectangular base plate 112 and a first sidewall 114 formed along an outer edge of the base plate 112.

Here, the first sidewall 114 may extend to surround an outer edge of the display panel coupled to the base plate 112, and may be configured in a rectangular ring shape along the outer edge of the display panel.

In one embodiment, the first sidewall 114 may be provided with a plurality of clinching nuts 116 to which a screw 130 fastened to a second sidewall 124 of the frame 120 to be described later is screwed.

In this structure, the distance between the first sidewall 114 of the module assembly 110 and the second sidewall 124 of the frame 120 may be adjusted by the screw coupling length of the screw 130 and the clinching nut 116.

The frame 120 is a structure that is installed in a housing of a game machine such as a slot machine and is coupled to the module assembly 110 to serve as a medium for installing a display panel in the housing of the game machine.

In one embodiment, the frame 120 may be configured in a rectangular ring shape corresponding to the rectangular module assembly 110.

In addition, in one embodiment, the frame 120 may include a bezel portion 122 surrounding the outside of the image display surface of the display panel in parallel with the image display surface, and a second sidewall 124 vertically bent from the outside of the bezel portion 122 toward the rear of the display panel.

The second sidewall 124 is disposed to face the first sidewall 114 of the module assembly 110.

The screw 130 is a fastener for coupling the first sidewall 114 of the module assembly 110 and the second sidewall 124 of the frame 120 to each other, and may be screwed to the clinching nut 116 of the first sidewall 114 from the outside of the second sidewall 124 as illustrated in FIG. **1****.**

In one embodiment, as shown in FIG. 1, the screws 130 may be disposed in plurality along the first sidewall 114 constituting the outer edge of the module assembly 110, at least one pair of the screws being disposed at symmetrical positions on an upper side and a lower side of the module assembly 110, and at least one pair of the screws being disposed at symmetrical positions on a left side and a right side of the module assembly 110.

In the display apparatus 100 according to one embodiment of the present disclosure having the above-described configuration, the left-right distance and the upper-lower distance between the module assembly 110 and the frame 120 may be uniformly adjusted through the screws 130 provided at positions symmetrical to each other with respect to the module assembly 110 so that the module assembly 110 is aligned at a desired position with respect to the frame 120.

On the other hand, when the screws 130 symmetrical to the upper and lower sides and the left and right sides of the module assembly 110 are not disposed and the screws 130 are disposed to be misaligned with each other, the module assembly 110 is likely to be tilted with respect to the frame 120.

Meanwhile, as illustrated in FIG. 1, in one embodiment, a structure in which a plurality of screws 130 are symmetrically disposed on the upper, lower, left, and right sides of the module assembly 110 may be more preferable in terms of alignment accuracy of the module assembly 110 and coupling stability between the module assembly 110 and the frame 120.

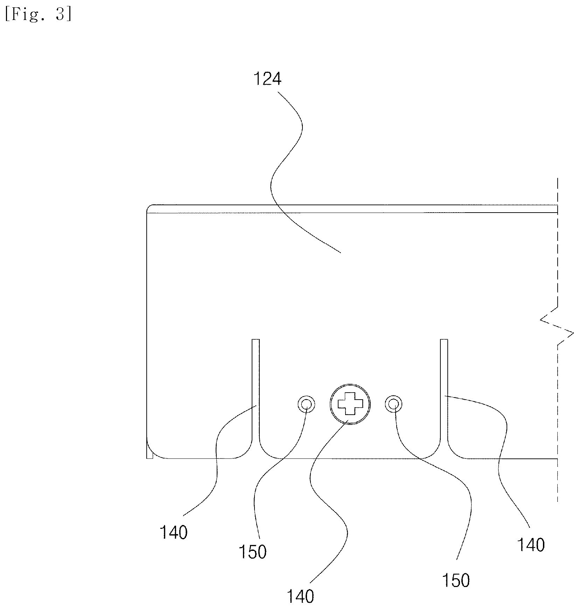

The cut-out portion 140 is a portion in which a portion of the second sidewall 124 is cut, and as illustrated in FIG. 3, may be formed by being cut from one side end portion of the second sidewall 124 in the width direction to the other side end portion on both sides of the screw 130 in the second sidewall 124.

The cut-out portion 140 may be formed at both sides of the screw 130 so that when excessive coupling force is applied to the first sidewall 114 and/or the second sidewall 124 by machining error, coupling failure, or the like by the screw 130 or a fine error occurs in the coupling position of the screw 130, the second sidewall 124 may be deformed only within the range of the cut-out portion 140 and deformation may not be conducted over the entire second sidewall 124.

In order to perform this function, in one embodiment, the cut-out 140 is preferably cut from one end of the second sidewall 124 to a position beyond the position of the screw 130, as shown in FIG. 3.

However, the second sidewall 124 needs to maintain high rigidity between a section in which the cut-out portion 140 is formed and a section in which the cut-out portion 140 is not formed so that the entire second sidewall 124 may be stably fastened to the first sidewall 114 by the fastening force of the screw 130 generated within the range of the cut-out portion 140.

Accordingly, in one embodiment, the cut-out 140 may be cut only up to half the width of the second sidewall 124

The gap limiting member 150 may be provided between the first sidewall 114 and the second sidewall 124 to determine a gap between the first sidewall 114 and the second sidewall 124.

That is, even when the screw 130 is excessively rotated while the first sidewall 114 and the second sidewall 124 are assembled with each other through the screw 130 from one side, the gap limiting member 150 may perform a function of a stopper and an alignment key that suppresses the movement of the module assembly 110 to prevent the module assembly 110 from being aligned at a correct position with respect to the frame 120 and from being coupled to be asymmetrically coupled or tilted with respect to the frame 120.

The gap limiting member 150 may be configured as a separate member assembled or bonded between the first sidewall 114 and the second sidewall 124, but when configured as described above, an additional process of aligning the position of the gap limiting member 150 itself and securing assembly uniformity is required.

Therefore, in order to omit this process, in one embodiment, the gap limiting member 150 may be formed by embossing the second sidewall 124 and integrally protruding from the inner surface of the second sidewall 124. For example, as illustrated in the example, the gap limiting member 150 may be embossed on the second sidewall of the frame 120 to protrude toward the inner surface.

In another embodiment, the gap limiting member 150 may be embossed and formed on the first sidewall of the module assembly portion 110 to protrude outward.

In addition, in one embodiment, the gap limiting member 150 may be formed in a flat shape so that a surface facing the first sidewall 114 does not deform against the counterpart itself.

In detail, when the gap limiting member 150 facing the first sidewall 114 has a tapered or rounded shape, an end of the gap limiting member 150 may be deformed by a compressive load or break the first sidewall 114 when a strong rotational force is applied to the screw 130, but a structure having a flat end may be in surface contact with the first sidewall 114 to distribute the compressive load, and thus a probability of deformation occurring in the gap limiting member 150 may be lowered and damage to the first sidewall 114 may be prevented.

In addition, in one embodiment, the gap limiting member 150 may protrude by 0.15 to 0.25mm shorter than a preset gap between the first sidewall 114 and the second sidewall 124 generated by assembling the module assembly 110 and the frame 120.

As described above, the protruding length of the gap limiting member 150 may be slightly shorter than the desired gap between the first sidewall 114 and the second sidewall 124 in consideration of an error of NCT press processing used to perform embossing processing on the gap limiting member 150, but is not limited thereto, and the protruding length of the gap limiting member 150 may be configured to be the same as the desired gap between the first sidewall 114 and the second sidewall 124 as long as precise embossing processing may be implemented.

Meanwhile, a plurality of such gap limiting members 150 may be disposed along the outer edge of the module assembly 110, at least one pair of the gap limiting members being disposed at symmetrical positions on an upper side and a lower side of the module assembly 110, and at least one pair of the gap limiting members being disposed at symmetrical positions on a left side and a right side of the module assembly 110.

As described above, the configuration in which the gap limiting members 150 are disposed to be symmetrical to the upper, lower, left, and right sides of the module assembly 110, respectively, aims to align the module assembly 110 with respect to the frame 120, prevent a tilt, and prevent a shift, similar to the above-described symmetrical arrangement of the screws 130, and thus a detailed explanation of the reason is omitted.

Meanwhile, in one embodiment, the gap limiting member 150 may be provided between the screw 130 and the cut-out portion 140 as illustrated in FIG. 3.

In one embodiment, a pair of the gap limiting members 150 may be disposed in a symmetrical shape on both sides (including the up-down direction and the left-right direction) of the screw 130.

As described above, the gap limiting members 150 symmetrically disposed at both sides of the screw 130 may symmetrically resist the compressive stress applied by the coupling of the screw 130 based on the screw 130, thereby reducing the possibility of deformation of the second sidewall 124.

Meanwhile, in one embodiment, the gap limiting member 150 may be disposed between the screw 130 and the cut-out portion 140.

On the other hand, when the gap limiting member 150 is disposed to be parallel to the cutting direction of the cut-out portion 140, the gap limiting member 150 and the screw 130 overlap each other from the viewpoint of being viewed from the end of the second sidewall 124, and thus it may be impossible to check the gap between the gap limiting member 150 and the first sidewall 114 overlapping the screw 130 after the module assembly 110 and the frame 120 are assembled.

In addition, in one embodiment, the gap limiting member 150 may be disposed closer to the screw 130 between the screw 130 and the cut-out 140. This configuration may not affect the deformation of the second sidewall 124 when the screw 130 is assembled.

A coupling structure between the module assembly 110 and the frame 120 of the display device 100 according to one embodiment of the present disclosure will be described with reference to FIG. 5.

As illustrated in FIG. 5, in the display device 100 according to one embodiment of the present disclosure, when the module assembly 110 and the frame 120 are assembled, the gap between the module assembly 110 and the frame 120 may be set to correspond to a desired design value by adjusting the protruding height of the gap limiting member 150, and the uniformity of the gap between the module assembly 110 and the frame 120 may be easily secured even during the assembly process.

That is, when the operator assembles the module assembly 110 and the frame 120 in a state of being in contact with or being close to the gap limiting member 150 when performing the assembly work with the module assembly 110 on one side of the frame 120, the gap uniformity may be secured even in the remaining portions.

In particular, the display apparatus 100 according to one embodiment of the present disclosure has an advantage in that it is easy to assemble the module assembly 110 in a state of being aligned with the frame 120 even under a working environment in which the module assembly 110 and the screws 130 disposed on one side of the frame 120 should be coupled first and then the screws 130 disposed on the other side should be coupled.

While the present disclosure has been described and illustrated with reference to specific embodiments, it should be understood that those skilled in the art may make various modifications and changes to the invention without departing from the spirit and scope of the invention as defined in the appended claims.

### <Description of Reference Numerals>

- 100:: display device
- 110:: module assembly
- 112:: base plate
- 114:: first sidewall
- 116:: clinching nuts
- 120:: frame
- 122:: bezel portion
- 124:: second sidewall
- 130:: screw
- 140:: cut-out portion
- 150:: gap limiting member

### Industrial Applicability

According to an embodiment of the present disclosure, the assembly accuracy and precision between the module assembly and the frame can be improved, and the assembly difficulty can be reduced, thereby significantly decreasing the likelihood of deformation and damage to the display device and enhancing industrial applicability.

## Claims

1. A display device comprising:
a module assembly to which a display panel is coupled, the module assembly comprising a first sidewall formed along an outer edge of the display panel;
a frame comprising a second sidewall facing the first sidewall;
a screw configured to fasten the first sidewall and the second sidewall to each other; and
a gap limiting member disposed between the first sidewall and the second sidewall to determine a gap between the first sidewall and the second sidewall.

2. The display device of claim 1,
wherein the gap limiting members are disposed in plurality along the outer edge of the module assembly, at least one pair of the gap limiting members being disposed at symmetrical positions on an upper side and a lower side of the module assembly, and at least one pair of the gap limiting members being disposed at symmetrical positions on a left side and a right side of the module assembly.

3. The display device of claim 1,
wherein the gap limiting member is formed by embossing the second sidewall and integrally protruding from an inner surface of the second sidewall.

4. The display device of claim 2,
wherein the screws are disposed in plurality along the outer edge of the module assembly, at least one pair of the screws being disposed at symmetrical positions on an upper side and a lower side of the module assembly, and at least one pair of the screws being disposed at symmetrical positions on a left side and a right side of the module assembly, and
wherein the pair of the gap limiting members are symmetrically disposed with respect to the screw.

5. The display device of claim 4,
wherein the second sidewall comprises a cut-out portion formed by cutting both sides of the screw in a direction from one end portion of the second sidewall in a width direction to the other end portion thereof.

6. The display device of claim 5,
wherein the gap limiting member is disposed between the screw and the cut-out portion.

7. The display device of claim 6,
wherein the gap limiting member is disposed closer to the screw between the screw and the cut-out portion.

8. The display device of claim 1,
wherein a surface of the gap limiting member facing the first sidewall is flat.

9. The display device of claim 3,
wherein the gap limiting member protrudes to be 0.15 mm to 0.25 mm shorter than a preset gap between the first sidewall and the second sidewall, the preset gap being formed when the module assembly and the frame are coupled.

10. A frame installed in a housing of a gaming machine such as a slot machine, coupled with a module assembly, and serving as a medium to mount a display panel to the housing of the gaming machine, the frame comprising:
a bezel portion surrounding an outer edge of an image display surface of the display panel in parallel with the image display surface;
a second sidewall bent vertically from the outer edge of the bezel portion to a rear side of the display panel and disposed to face a first sidewall of the module assembly; and
a gap limiting member disposed between the first sidewall and the second sidewall.

11. The frame of claim 10,
wherein the gap limiting members are disposed in plurality along the outer edge of the module assembly, at least one pair of the gap limiting members being disposed at symmetrical positions on an upper side and a lower side of the module assembly, and at least one pair of the gap limiting members being disposed at symmetrical positions on a left side and a right side of the module assembly.

12. The frame of claim 10,
wherein the gap limiting member is formed by embossing the second sidewall and integrally protruding from an inner surface of the second sidewall.

13. The frame of claim 11,
wherein the frame is coupled to the module assembly by a screw fastening the first sidewall and the second sidewall to each other.

14. The frame of claim 13,
wherein the screws are disposed in plurality along the outer edge of the module assembly, at least one pair of the screws being disposed at symmetrical positions on an upper side and a lower side of the module assembly, and at least one pair of the screws being disposed at symmetrical positions on a left side and a right side of the module assembly, and
wherein the pair of the gap limiting members are symmetrically disposed with respect to the screw.

15. The frame of claim 14,
wherein the second sidewall comprises a cut-out portion formed by cutting both sides of the screw in a direction from one end portion of the second sidewall in a width direction to the other end portion thereof.

16. The frame of claim 15,
wherein the gap limiting member is disposed between the screw and the cut-out portion.

17. The frame of claim 12,
wherein the gap limiting member protrudes to be 0.15 mm to 0.25 mm shorter than a preset gap between the first sidewall and the second sidewall, the preset gap being formed when the module assembly and the frame are coupled.
